# DEMANDE DE BREVET EUROPEEN

(11) **EP 1 993 147 A1**
(43) Date de publication de la demande: **19.11.2008**
(21) Numéro de dépôt: 08368013.2
(22) Date de dépôt: 13.05.2008
(51) Int. Cl.: H01L 31/113

(54) **Transistor MOSFET détecteur modulateur et son procédé de fabrication**

(30) Priorité: 14.05.2007 FR 0703448
(71) Demandeur: STMicroelectronics S.A., 92120 Montrouge (FR)
(72) Inventeur: Abele, Nicolas, 75006 Paris (FR)
(74) Mandataire: Schuffenecker, Thierry

(57) **Abrégé**

Transistor MOSFET détecteur modulateur de lumière comportant :
- un substrat (100) recevant un rayonnement lumineux, ledit substrat ayant deux zones de source (110) et de drain (120) séparées par un canal (130) s'étendant suivant une première direction,
- une poutre conductrice de grille (140) s'étendant suivant une seconde direction sensiblement perpendiculaire à ladite première direction, ladite poutre étant fixée à ses deux extrémités sur deux points d'appui (150) et étant disposée au-dessus de la zone de canal (130), ladite poutre de grille étant significativement opaque et flexible de manière à permettre une modulation progressive de la lumière atteignant le canal (130) en fonction d'une flexion commandée par l'application d'une différence de potentiel entre la grille et le substrat et venant rapprocher la poutre de la surface du canal.

L'invention réalise également un procédé de fabrication d'un transistor MOSFET détecteur modulateur.

## Description

### Domaine technique de l'invention

La présente invention concerne le domaine des circuits électroniques et plus spécifiquement un transistor MOSFET détecteur-modulateur de lumière et un procédé de fabrication de ce dernier.

### Etat de la technique

La figure 1 décrit un dispositif connu de modulateur de lumière, décrit dans la demande de brevet américaine US 2002047564 déposée au nom de LG PHILIPS LCD Co LTD. On y voit une structure de modulateur localisé au-dessus d'un détecteur (non représenté), la structure étant basé sur un substrat de silicium 11 sur lequel est disposé un premier jeu de masques opaques 12 séparés par des fenêtres permettant le passage de la lumière. Des volets 13 de tailles différentes sont commandables individuellement de manière à venir occulter un, deux ou plusieurs volets et ainsi moduler la lumière parvenant sur un photocapteur situé sous le jeu de volets. Les volets sont actionnés par une tension dite de PULL-IN commandant une force électrostatique. Au delà d'un certain seuil, la force électrostatique provoque un phénomène de collage des poutres sur la partie du silicium, entraînant ainsi la modulation de la lumière arrivant sur la partie sensible à la lumière. Chacun des volets fonctionnant en « tout ou rien », la modulation de la lumière est ainsi assurée, dans ce premier système connu, au moyen d'une commande et d'un adressage différentié de chacun des volets. D'une manière générale, le procédé de fabrication d'un tel dispositif est particulièrement complexe à mettre en oeuvre.

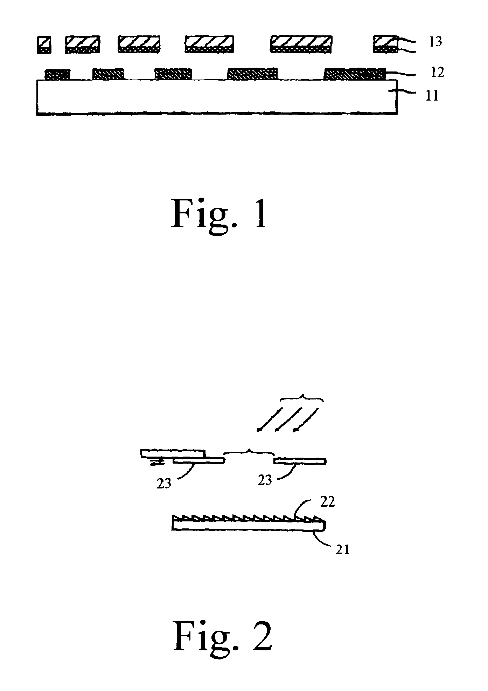

La figure 2 illustre un second dispositif connu permettant de moduler la lumière au moyen de l'actionnement d'un volet 23 se déplaçant horizontalement et venant obturer en tout ou en partie une fenêtre permettant le passage d'un rayon lumineux venant atteindre un substrat 21 doté de capteurs 22.

Les dispositifs précédents ne permettent pas la réalisation d'un capteur - modulateur intégré et il faut alors associer aux modulateurs connus un capteur connu venant réduire l'espace disponible sur le circuit intégré.

D'une manière générale, il est souhaitable de pouvoir réaliser, au moyen des techniques standards de fabrication de circuits CMOS, un structure de transistor qui réalise simultanément les deux fonctions recherchées de capteur et modulateur de lumière.

Tel est l'objet de la présente invention.

### Exposé de l'invention

La présente invention a pour but de proposer une structure de composant réalisant la double fonction de détecteur de lumière et de modulateur, permettant de réduire l'espace occupé dans un circuit intégré.

Un autre but de la présente invention consiste à proposer un procédé de fabrication très proche des techniques classiques de fabrication CMOS qui permet de réaliser un transistor MOSFET détecteur modulateur.

L'invention réalise ces buts au moyen d'un transistor MOSFET détecteur modulateur de lumière comportant :
- un substrat recevant un rayonnement lumineux, ledit substrat ayant deux zones de source et de drain séparées par un canal semiconducteur s'étendant suivant une première direction,
- une poutre conductrice de grille s'étendant suivant une seconde direction sensiblement perpendiculaire à ladite première direction, ladite poutre étant fixée à ses deux extrémités sur deux points d'appui et étant disposée au-dessus de la zone de canal (130).

La poutre de grille est significativement opaque et flexible de manière à permettre une modulation progressive de la lumière atteignant le canal en fonction d'une flexion commandée par l'application d'une différence de potentiel entre la grille et le substrat et venant rapprocher la poutre de la surface du canal.

On réalise ainsi, très simplement, un transistor MOSFET qui cumule les fonctions de détecteur et modulateur et qui est fabriqué suivant des techniques standards en technologie CMOS. Il en résulte un gain significatif de place et de coût.

Dans un mode de réalisation particulier, la poutre de grille est ancrée à ses deux extrémités sur des zones STI. Alternativement, on pourra réaliser le transistor sur un substrat de type SOI (*Silicon On Insulator*).

L'invention réalise également un procédé de fabrication d'un transistor MOSFET détecteur modulateur de courant comportant les étapes suivantes :
- préparation d'un substrat sur lequel on vient disposer une couche d'oxyde sacrificielle
- croissance d'une couche de silicium polycristallin
- gravure de ladite couche de silicium polycristallin de manière à réaliser une poutre fixée sur deux points d'ancrages positionnés sur le substrat;
- implantation de zones de source et de drain disposée de part et d'autre de ladite poutre qui vient surplomber le canal ;
- suppression de ladite couche d'oxyde sacrificielle de manière à libérer ladite poutre suspendue ;
- oxydation de ladite poutre afin de fixer les propriétés électriques de celle-ci ;
- conditionnement ultérieur de la structure.

Dans un mode de réalisation, la couche d'oxyde sacrificielle est réalisée en bain humide employant un acide BHF

Dans un mode de réalisation, l'oxydation de la poutre flexible est réalisée par une oxydation thermique ou par apport de couche d'oxyde conforme.

Dans un mode de réalisation, le conditionnement ultérieur de la structure du transistor détecteur modulateur est réalisé au moyen des étapes suivantes :
- dépôt par pulvérisation d'une couche de silicium amorphe ou polysilicium conforme ;
- dépôt d'une couche d'oxyde ou de nitrure venant recouvrir la couche de silicium amorphe ;
- ouverture de vias de contacts sur les zones de drain, source et de grille et métallisation de ces vias de manière à constituer les électrodes de drain, de source et de grille respectivement ;
- ouverture de vias de libération et suppression de la couche de silicium amorphe ou polysilicium conforme;
- dépôt d'une couche non conforme d'oxyde venant recouvrir les métallisation ainsi que les vias de libération.
- Ouverture de vias de reprise de contact à travers l'oxyde

### Description des dessins

D'autres caractéristiques, but et avantages de l'invention apparaîtront à la lecture de la description et des dessins ci-après, donnés uniquement à titre d'exemples non limitatifs. Sur les dessins annexés :
Les figures 1 et 2 illustrent deux structures connues de modulateurs de lumière.
La figure 3 illustre un mode de réalisation d'un transistor MOS détecteur et modulateur de courant conforme à la présente invention.
La figure 4 est une élevation illustrant la poutre flexible opaque servant de grille dans le transistor MOSFET selon l'invention
La figure 5 illustre la même élevation que la figure 4, mais montrant la poutre dans une situation de flexion venant réduire la quantité de lumière parvenant sur le canal et, par conséquent, l'inversion de ce même canal.
La figure 6 illustre la courbe Id (Vg) du transistor MOSFET selon la présente invention.
Les Figures 7a à 7j illustrent un premier mode de réalisation d'un transistor MOSFET selon la présente invention à partir d'un substrat standard.
Les figures 8a à 8h illustrent un second mode de réalisation d'un transistor MOSFET selon la présente invention à partir d'un substrat SOI (Silicon on insulator)

### Description d'un mode de réalisation préféré

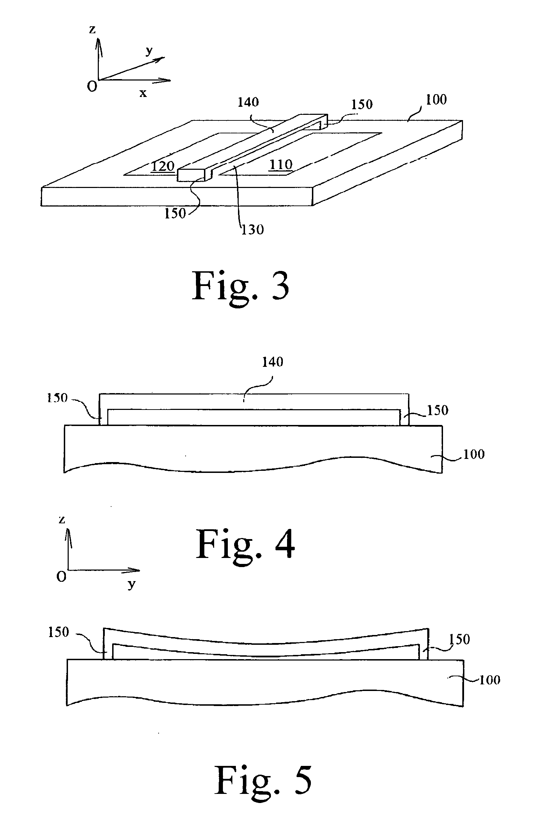

La figure 3 est une vue en perspective la structure de base d'un transistor MOSFET détecteur-modulateur conforme à la présente invention.

Le transistor MOSFET comporte un substrat 100 réalisé à partir d'un matériau semiconducteur, sur lequel on a disposé deux régions dopées 110 et 120 définissant respectivement une zone de source et une zone de drain. Les deux zones de source et de drain sont séparées par un canal 130 qui, comme on le voit sur la figure 3 s'étend suivant un premier axe 0-x.

Le transistor MOS comporte ensuite une poutre de grille 140 - réalisée en un matériau conducteur, flexible, sensiblement opaque - s'étendant suivant un second axe sensiblement perpendiculaire 0-y . La poutre de grille est disposée au-dessus d'une partie du canal 130.

La poutre de grille flexible 140 est fixée sur le substrat 100 au moyen de deux appuis 150 permettant la libre flexion au dessus de la région du canal 130 sous l'effet d'une force électrostatique commandée par un potentiel appliqué à la grille par rapport au potentiel du substrat (*BULK*) ou canal considéré comme étant à la masse.

La figure 4 illustre la poutre suspendue au repos tandis que la figure 5 illustre la même poutre en flexion.

Lorsque la force électrostatique commandé par le potentiel de grille vient fléchir la poutre opaque 140, il en résulte une modification de l'inversion du canal modifiant la caractéristique Id(Vg) du transistor MOSFET.

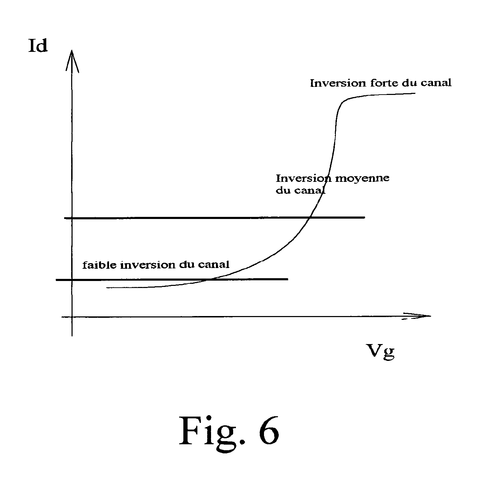

La figure 6 illustre cette caractéristique courant Id -tension Vg d'un transistor MOSFET. Dans la présente invention, la zone de fonctionnement recherchée est située dans le premier tiers du « gap » (distance entre la grille et l'oxide de grille) disponible pour assurer la flexion de la poutre de manière à éviter tout effet de PULL-IN que l'on rencontrait dans les dispositifs connus provoquant le « collage » de la poutre de grille et, par suite, la détérioration de la surface du canal. Dans l'application de l'invention proposée, on évite l'effet de collage de manière à préserver intacte la surface du canal.

Dans ces conditions, lorsque le dispositif est placé dans l'obscurité, on observe un très faible courant avec toutefois un pic de 1 à 2 décades lorsque qu'une source lumineuse est appliquée, ce qui est relativement important et facile à détecter.

Lorsque la luminosité s'accroît de manière significative, on constate alors un phénomène d'inversion du canal et, corrélativement, un accroissement considérable du courant Id dans le canal.

La courbe Id (Vg) est modifiée de manière significative lorsque l'on vient fléchir la poutre 140 au moyen d'un potentiel appliqué sur cette poutre par rapport au potentiel du substrat (ou *Bulk*). En effet, lorsque la poutre fléchit comme cela est illustré dans la figure 5, cette dernière vient recouvrir de son ombre une surface significative du canal, réduisant ainsi le phénomène d'inversion assurant la conduction du transistor MOSFET. On peut ainsi, en venant régler la différence de potentiel entre la grille et le substrat moduler de manière progressive la lumière appliquée sur la surface du canal du transistor et, par suite, éviter les phénomènes de saturation en cas de luminosité trop importante .

Dans la position de repos, on fera en sorte que la poutre fléchisse légèrement vers le canal. lorsque la luminosité est réduite, on peut venir réduire le potentiel appliqué à la grille de manière à éloigner cette dernière de la surface du canal pour, finalement, permettre à d'avantage de rayons lumineux d'aller exciter la surface du canal.

Ainsi, on réalise très simplement un dispositif de modulation de lumière particulièrement efficace. La modulation est obtenue par le jeu d'une seule commande appliquée sur la grille et ne nécessite pas une commande complexe comme dans le brevet US 2002047564 précité, basé sur un adressage différentié des différents volets.

D'une manière générale, le transistor MOS détecteur modulateur qui vient d'être décrit peut être réalisé de multiples façons au moyen des techniques standards utilisées en technologie CMOS et bien connues d'un homme du métier.

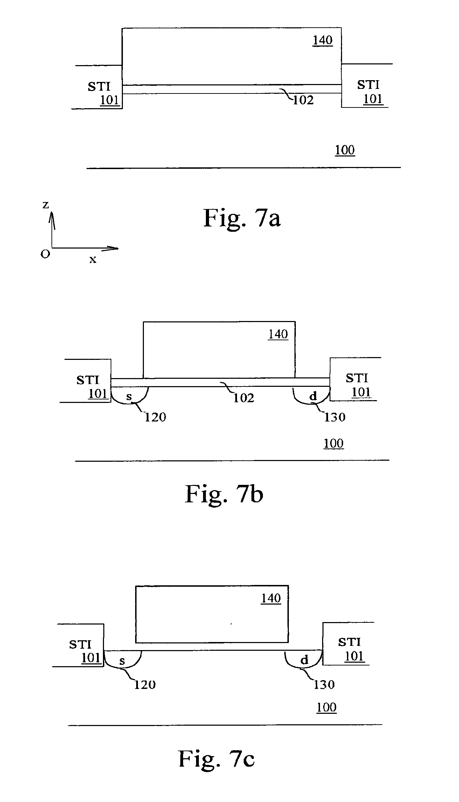

On décrit ci-après un premier mode de réalisation particulier d'un transistor MOSFET conforme à la présente invention, en relation avec les figures 7a à 7e. Dans cette description, les techniques préliminaires du procédé qui sont bien connues d'un homme du métier ne seront pas reprises en détail.

Comme cela est illustré en figure 7a, le procédé commence par la préparation d'un substrat classique 100 (dit *bulk*) doté de tranchées STI 101 (*Shallow Trench Insulator*) permettant d'assurer l'isolation électrique des différentes structures positionnées sur un même substrat. La technique dite STI est bien connue d'un homme du métier et ne sera pas décrite plus avant. Le substrat 100 est, par exemple en silicium monocristallin (Si), recouverte d'une couche sacrificielle d'oxyde 102, tel que de la silice (SiO₂).

On réalise par la suite une épitaxie non sélective conduisant à la formation d'une couche de silicium poly cristallin 140.

Dans une étape ultérieure, comme cela est illustré dans la figure 7b, on vient graver la couche de silicium polycristallin de manière à réaliser la poutre conductrice de grille 140 de la figure 3. La figure n'illustre pas les ancrages ou points d'appuis 150 de la figure 3 car ceux-ci sont disposés de part et d'autre du plan de la figure 7b, en avant et en arrière, et prennent position sur les zones STI ou même directement sur le silicium du substrat 100 après gravure sélective de la zone d'oxyde.

On réalise ensuite des zones d'implantation de source et de drain, respectivement 120 et 130, qui sont disposées de part et d'autre de la poutre de grille de telle sorte que celle ci vienne surplomber la zone de canal. Bien évidemment, la nature de l'implantation viendra déterminer le type de transistor qui sera réalisé, NMOS ou PMOS. En outre, on adaptera l'énergie de l'implantation en fonction de l'épaisseur de la couche d'oxyde 102 à traverser. Si la couche d'oxyde 102 est particulièrement épaisse on pourra alors envisager une gravure à sec par exemple, préalablement à l'opération d'implant. Toutes ces techniques sont bien connues d'un homme du métier et ne seront donc pas reprises plus avant.

Dans une étape ultérieure, représentée dans la figure 7c, on vient ensuite supprimer la couche d'oxyde sacrificielle 102 au moyen de toute technique connue, telle que par exemple un bain humide employant un acide BHF.

On effectue ensuite une oxydation thermique ou une déposition d'un oxyde conforme permettant de fixer les propriétés de la poutre de grille et du canal du semiconducteur.

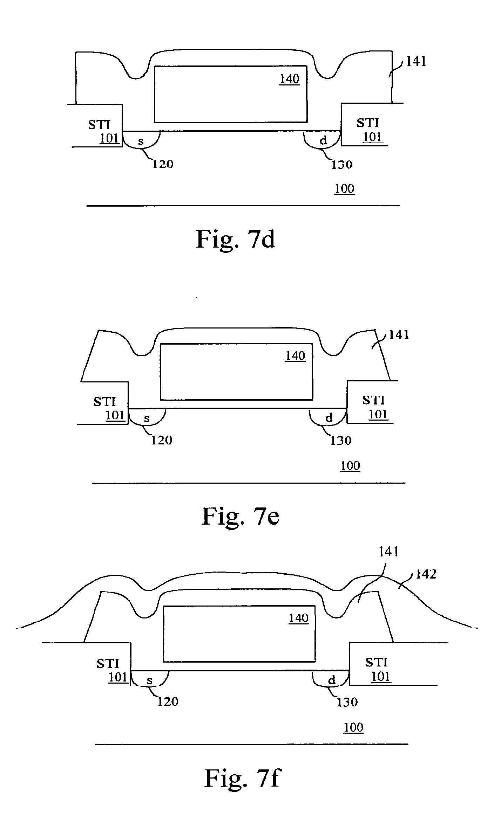

La structure de poutre de grille est à présent achevée et l'on finalise la structure au moyen d'un procédé de conditionnement adéquat, tel que, par exemple, le procédé illustré dans les figures 7d à 7j.

Ce conditionnement débute par une étape de pulvérisation (ou « *sputtering* ») de silicium amorphe venant déposer une couche sacrificielle 141. Alternativement, on pourra déposer une couche de polysilicium conforme - i.e. sans orientation préférentielle - au moyen de techniques bien connues.

On grave ensuite cette couche 141 de manière à former deux flancs en biais, respectivement à gauche et à droite, de la couche 141, comme cela est illustré dans la figure 7e.

On procède ensuite, comme illustré dans la figure 7f, au dépôt d'une couche structurelle 142 permettant le maintien du capot du produit semi-conducteur, que l'on réalise au moyen d'un dépôt d'une couche d'oxyde ou de nitrure appropriée.

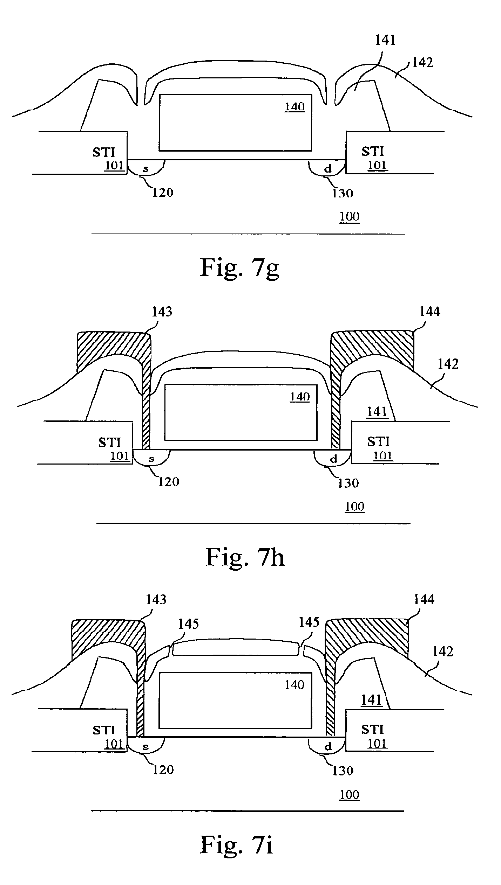

On procède ensuite à l'ouverture de vias de contacts sur les zones de drain, de source comme cela est illustré dans la figure 7g. On réalise également un via sur l'un des ancrages de la poutre de grille de manière à assurer la réalisation d'un contact de grille (non visible sur la figure 7g). On effectue ensuite une métallisation de ces vias de contacts de manière à créer les électrodes de contact des zones source, drain et grille. La figure 7h illustre les métallisations des électrodes de drain et de source, respectivement référencées 143 et 144 qui viennent en contact avec les zones 120 et 130.

On réalise ensuite, comme illustré dans la figure 7i, des vias dits de libération (ou « *release* » ), à savoir des orifices suffisamment fins pour permettre un accès à la couche sacrificielle de silicium amorphe 141, que l'on supprime ensuite par des moyens connus de gravure sèche.

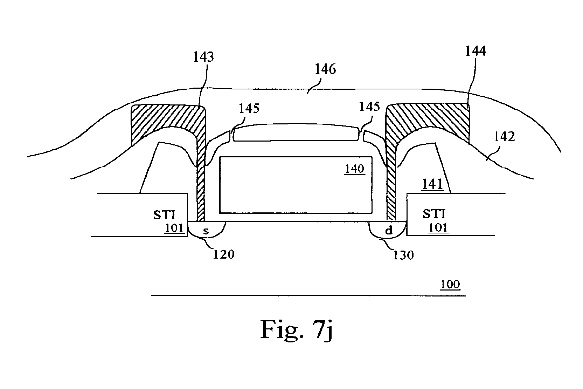

On effectue ensuite, tel qu'illustré dans la figure 7j, le dépôt d'une couche d'oxyde non conforme permettant de recouvrir les métallisations effectuées dans les vias de contacts ainsi que les orifices des vias de release.

On obtient ainsi une structure de transistor MOS détecteur-modulateur proprement conditionnée.

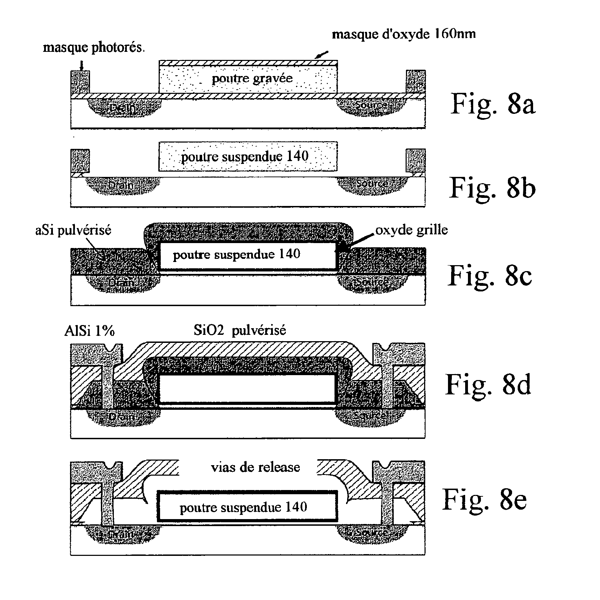

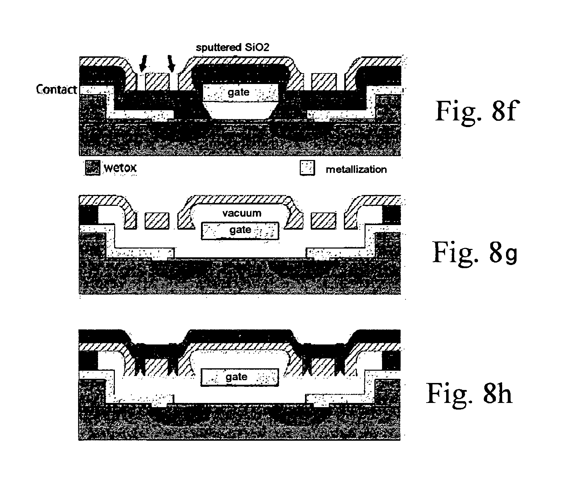

Les figures 8a à 8e illustrent un second mode de réalisation du procédé basé sur l'utilisation d'un substrat de type SOI ( *Silicon on Insulator*) qui est basé sur une fine couche d'oxyde et une fine couche de silicium. Une tel substrat dit SOI présente l'avantage, comme cela est connu, d'assurer une isolation électrique par rapport au substrat et, d'autre part, d'assurer la croissance d'un silicium de type monocristallin.

On a un utilisé un substrat SOI de 200 mm d'épaisseur avec une couche d'oxyde BOX (Buried Oxide) de 50nm et une couche de silicium de 100nm non dopée. On épitaxie ensuite une couche de silicium dopée avec du phosphore présentant une épaisseur de 900 nm est épitaxiée afin d'assurer un profil de dopage uniforme sur toute l'épaisseur. Une couche d'oxyde de 160nm est déposée à faible température afin de servir de masque pour la gravure de la poutre. Pour doper la couche de silicium de 100nm originelle du substrat SOI, on réalise une opération de recuit.

Pour cette étape, la couche fine d'oxyde servant de masque évite l'amorphisation de la surface du silicium durant le recuit.

Pour effectuer la gravure de la poutre de grille, on utilise une solution combinant une Gravure BHF avec un séchage de point critique (CPD) pour éviter le collage de la structure. L'oxydation de la grille est réalisée au moyen d'une oxydation sèche de la poutre suspendue.

Une fois la poutre libérée, une protection contre l'eau mais également contre les étapes ultérieures de métallisation est requise et, à cet effet, on utilise un silicium amorphe pulvérisé qui apporte une protection satisfaisante tout en évitant, toutefois, de venir remplir l'espace sous la poutre de grille, facilitant ainsi le traitement total de la structure. Cette opération de pulvérisation d'un silicium amorphe à faible température se révèle avoir peu d'impact sur la structure active. Cette étape présente également un avantage décisif en raison de la protection apportée à l'oxyde de grille durant les étapes ultérieures de conditionnement.
En pratique, on a gravé cette couche et le substrat fut couvert par un oxyde d'une épaisseur de 1.8µm pulvérisé à température ambiante. Même déposé à une faible température, l'oxyde présente une conformité satisfaisante autour des coins de la poutre suspendue.
Les contacts sont gravés à travers l'oxyde épais et des tampons d' AISi 1% pulvérisés à température ambiante furent gravés sur le dessus de cet oxide. Un recuit à 400°C fut ensuite appliqués au composé AlSi de manière à réduire la résistance de contact. La dernière étape de masquage consista à l'ouverture de l'oxyde au moyen d'une gravure sèche pour accéder au silicium amorphe sacrificiel.

La libération définitive de la poutre fut réalisée au moyen d'une gravure chimique par plasma SF6 qui permit une grande sélectivité pour l'oxyde fin de grille entourant la grille de silicium.

Pour le procédé de conditionnement, on a pulvérisé une couche de silicium amorphe (aSi) de 5µm d'épaisseur sur la poutre suspendue, suivie ensuite d'une pulvérisation d'un film de 2µm de silice SiO2. Un procédé de déposition d'un film de aSi excluant tout stress est effectué, la déposition quasi-verticale permettant le dépôt de matière sous le rayon, réduisant ainsi le temps de libération. Des vias de libération de 1.5µm furent graves au travers la couche de SiO2 et l'étape de libération fut réalisé par un plasma sec SF6. La gravure pure chimique permit d'atteindre une sélectivité inférieure à 1 nm/min sur la couche de silice SiO2. Les vias furent enfin obturés par un dépôt par pulvérisation de SiO2 non conforme à température ambiante.

## Revendications

1. Transistor MOSFET détecteur modulateur de lumière comportant :
- un substrat (100) recevant un rayonnement lumineux, ledit substrat ayant deux zones de source (110) et de drain (120) séparées par un canal (130) s'étendant suivant une première direction,
- une poutre conductrice de grille (140) s'étendant suivant une seconde direction sensiblement perpendiculaire à ladite première direction, ladite poutre étant fixée à ses deux extrémités sur un ou plusieurs points d'appui (150) et étant disposée au-dessus de la zone de canal (130), ladite poutre de grille étant significativement opaque et flexible de manière à permettre une modulation progressive de la lumière atteignant le canal (130) en fonction d'une flexion commandée par l'application d'une différence de potentiel entre la grille et le substrat et venant rapprocher la poutre de la surface du canal.

2. Transistor MOSFET selon la revendication 1 **caractérisé en ce que** la poutre de grille est fixée à ses deux extrémités sur deux ancrages disposés sur des zones STI.

3. Transistor MOSFET selon la revendication 1 **caractérisé en ce qu'**il est réalisé à partir d'un substrat de type SOI.

4. Transistor MOSFET selon l'une quelconque des revendications 1 à 3 **caractérisé en ce que** ledit transistor MOSFET est de type NMOS .

5. Transistor MOSFET selon l'une quelconque des revendications 1 à 3 **caractérisé en ce que** ledit transistor MOSFET est de type PMOS.

6. Procédé de fabrication d'un transistor MOS détecteur- modulateur de courant comportant les étapes suivantes :
- préparation d'un substrat (100) sur lequel on vient disposer une couche d'oxyde sacrificielle (102)
- croissance ou dépôt d'une couche de silicium polycristallin (140)
- gravure de ladite couche de silicium polycristallin (140) de manière à réaliser une poutre flexible et sensiblement opaque fixée sur deux points d'ancrages positionnés sur le substrat (100) ;
- implantation de zones de source et de drain disposée de part et d'autre de ladite poutre qui vient surplomber le canal ;
- suppression de ladite couche d'oxyde (102) sacrificielle de manière à libérer ladite poutre suspendue (140) ;
- oxydation de ladite poutre (140) pour venir fixer les propriétés électriques de celle-ci ;
- dépôt de couches de conditionnement.

7. Procédé selon la revendication 6 **caractérisé en ce que** la suppression de ladite couche d'oxyde sacrificielle est réalisée en bain humide employant un acide BHF

8. Procédé selon la revendication 6 ou 7 **caractérisé en ce que** ladite oxydation de la poutre flexible est réalisée par une oxydation thermique ou par apport de couche d'oxyde conforme.

9. Procédé selon l'une quelconque des revendications 6 à 8 **caractérisé en ce que** le conditionnement comporte les étapes suivantes :
- dépôt par pulvérisation d'une couche de silicium amorphe (141) ou polysilicium conforme ;
- dépôt d'une couche d'oxyde ou de nitrure (142) venant recouvrir la couche de silicium amorphe ;
- ouverture de vias de contacts sur les zones de drain, source et de grille et métallisation de ces vias de manière à constituer les électrodes de drain, de source et de grille respectivement ;
- ouverture de vias de libération (release) (145) et suppression de la couche de silicium amorphe ou polysilicium conforme (141) ;
- dépôt d'une couche non conforme d'oxyde (146) venant recouvrir les métallisations ainsi que les vias de libération ;

10. Circuit détecteur modulateur de lumière comportant un ensemble de transistors MOSFET comportant :
- un substrat (100) recevant un rayonnement lumineux, ledit substrat ayant deux zones de source (110) et de drain (120) séparées par un canal (130) s'étendant suivant une première direction,
- une poutre conductrice de grille (140) s'étendant suivant une seconde direction sensiblement perpendiculaire à ladite première direction, ladite poutre étant fixée à ses deux extrémités sur deux points d'appui (150) et étant disposée au-dessus de la zone de canal (130), ladite poutre de grille étant significativement opaque et flexible de manière à permettre une modulation progressive de la lumière atteignant le canal (130) en fonction d'une flexion commandée par l'application d'une différence de potentiel entre la grille et le substrat et venant rapprocher la poutre de la surface du canal.
